Europäisches Patentamt

**European Patent Office**

Office européen des brevets

(19)

(11) Veröffentlichungsnummer: **0 062 318**
**A1**

(12) **EUROPÄISCHE PATENTANMELDUNG**

(21) Anmeldenummer: **82102796.8**

(22) Anmeldetag: **02.04.82**

(51) Int. Cl.³: **B 24 B 9/06**

(30) Priorität: **08.04.81 DE 3114078**

(43) Veröffentlichungstag der Anmeldung: **13.10.82**
Patentblatt 82/41

(84) Benannte Vertragsstaaten: **CH DE FR GB IT LI SE**

(71) Anmelder: **Löhr & Herrmann Ingenieurgesellschaft mbH,
Hesselbachstrasse 15, D-7531 Neuhausen (DE)**

(72) Erfinder: **Löhr, Hans-Günther, Dr. Ing., Ahornweg 3,
D-7135 Wiernsheim (DE)**
Erfinder: **Herrmann, Gunter, Dr., Lortzingstrasse 28,
D-7000 Stuttgart (DE)**

(74) Vertreter: **Hubbuch, Helmut Dipl.-Ing, Patentanwälte Dr.
Rudolf Bauer Dipl.-Ing. Helmut Hubbuch Dipl.-Phys.
Ulrich Twelmeier Westliche Karl-Friedrich-Strasse 29-31,
D-7530 Pforzheim (DE)**

(54) **Vorrichtung zum Kantenschleifen von plattenförmigem Gut.**

(57) Die Erfindung betrifft eine Vorrichtung zum Kantenschleifen — Glätten und Entgraten der Plattenränder —
von plattenförmigem Gut (1), insbesondere Leiterplatten
der Elektronikindustrie, wobei das Gut mittels wenigstens
teilweise angetriebenen Rollen (2, 3) an ein- oder beidseitig anliegenden Schleifscheiben (4) vorbeiführbar ist.
  Hierzu werden die Schleifscheibe(n) (4) als Umfangs-
schleifscheibe(n) bei Abnutzung unter nahezu konstant
gehaltener Federkraft (8) mit beim Kantenschleifen entstehender Umfangsnut (6) den Plattenrändern angelegt
und die mit der Nachstellung gekoppelte Abrichtung (9)
sorgt selbsttätig für etwa gleichbleibende Nuttiefe.

0062318

- 1 -

## Vorrichtung zum Kantenschleifen von plattenförmigem Gut

Die Erfindung betrifft eine Vorrichtung zum Kantenschleifen - Glätten und Entgraten der Plattenränder - von plattenförmigem Gut, insbesondere Leiterplatten der Elektronikindustrie, wobei das Gut mittels wenigstens teilweise angetriebenen Rollen an ein- oder beidseitig anliegenden Schleifscheiben vorbeiführbar ist.

Es ist bei plattenförmigem Gut und zwar bei Glasplatten bekannt zum Schleifen der Ränder die Platten auf Rollen gelagert und gegebenenfalls von diesen angetrieben an Profilschleifscheiben vorbeizuführen. Solche bekannten Verfahren sind jedoch nicht ohne weiteres auf das Kantenschleifen von Leiterplatten, wie solche für die Elektronikindustrie benötigt werden, anzuwenden. Beim Schleifen von Verbundmaterial, wie solches Leiterplatten darstellen, setzen sich die Schleifscheiben schnell zu, wodurch die Schleifwirkung verloren geht und das hierdurch notwendige Abziehen der Schleifscheiben häufige Arbeitsunterbrechungen erforderlich macht, so daß auf dieser Basis kaum zu arbeiten ist.

Beim Schleifen von Kanten von Leiterplatten sollen die beim Abschneiden oder Absägen der Leiterplatten entstehenden Grate sowie an der Schnittkante hängende Fasern beseitigt sowie die Schnittflächen eben geschliffen werden. Dieser Vorgang wird bisher manuell an Schleifbändern o.a. handbedienten Einrichtunge:

- 2 -

ausgeführt. Die Fasern stören bei der Weiterverarbeitung der Leiterplatten, da sie während der Weiterbearbeitung abbrechen können und die für die einwandfreie Herstellung von Leiterbahnen erforderliche saubere Oberfläche verschmutzen, wodurch die Leiterplatte sodann unbrauchbar wird.

Es ist nun Aufgabe der Erfindung vorallem für Verbundmaterial, wie Leiterplatten ein kontinuierliches Kantenschleifen und damit ein rationelles Arbeiten zu ermöglichen und Fasern, sowie Grate, welche bei der Weiterverarbeitung stören, zu beseitigen.

Hierzu kennzeichnet sich die Vorrichtung zum Kantenschleifen nach dem Oberbegriff von Anspruch 1 gemäß der Erfindung dadurch, daß die Schleifscheibe(n) als Umfangsschleifscheibe(n) bei Abnutzung unter nahezu konstant gehaltener Federkraft mit beim Kantenschleifen entstehender Umfangsnut den Plattenrändern anlegbar ist (sind) und die mit der Nachstellung gekoppelte Abrichtung selbsttätig für etwa gleichbleibende Nuttiefe sorgt. Hierfür ist (sind) die mit ihrer Antriebslagerung geführte(n) Schleifscheibe(n) bei unter Federwirkung stehender Schraubpinole(n) mit etwa konstanter Federkraft nachstellbar und auf jeder Schraubpinole sitzt eine Abrichtvorrichtung, welche am Umfang der Schleifscheibe anliegt. Hiermit wird bei gleichmäßiger Anpressung der Umfangsschleifscheibe eine nahezu konstante Tiefe der Schleifnut erhalten, wie das zum Kantenschleifen notwendig ist, ohne durch eine zu tief werdende

- 3 -

Schleifnut zu weit auf die Oberfläche des des Plattenguts zu beschädigen.

Im einzelnen kann hierbei das Schleifscheibenlager an einem quer zur Zustelleinrichtung liegenden Schwenkarm angeordnet sein und die Schraubpinole unter Zwischenschaltung einer Lasche zur Ausschaltung des Schwenkbogeneinflusses die Nachstellung bewirken, während die Schraubpinole aus einer dreh- und verschiebbar gelagerten, antreibbaren Aufnahmehülse - Pinolenantrieb - besteht, in welcher gegen Federwirkung eine mitdrehende Schraubhülse längsverschiebbar ist, welche mit Innengewinde einen nichtdrehbaren Druckbolzen verschraubbar für die Schleifscheibenzustellung und mit Außengewinde die längsgeführte Abrichtvorrichtung schraubbar aufnimmt. Hierbei besitzt das Außengewinde für die gleichläufige Abrichtvorrichtung gegenüber dem Innengewinde für die Schleifscheibenzustellung doppelte Steigung, so daß bei zustellbarer Schleifscheibe die Abrichtvorrichtung sowohl um die Zustellstrecke als auch um die Schleifabnutzungsstrecke anstellbar ist.

Weitere Einzelheiten der erfindungsgemäßen Vorrichtung sind sodann an Hand eines in der Zeichnung dargestellten bevorzugten Ausführungsbeispiels nachfolgend beschrieben und zwar zeigen:

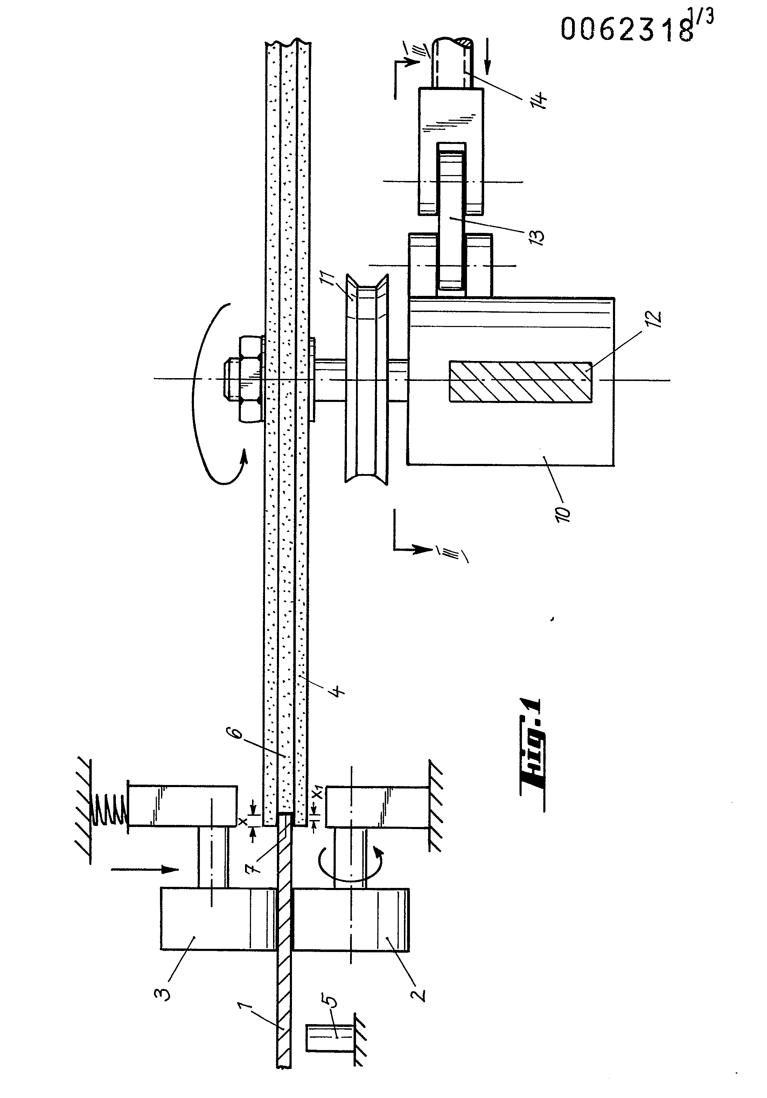

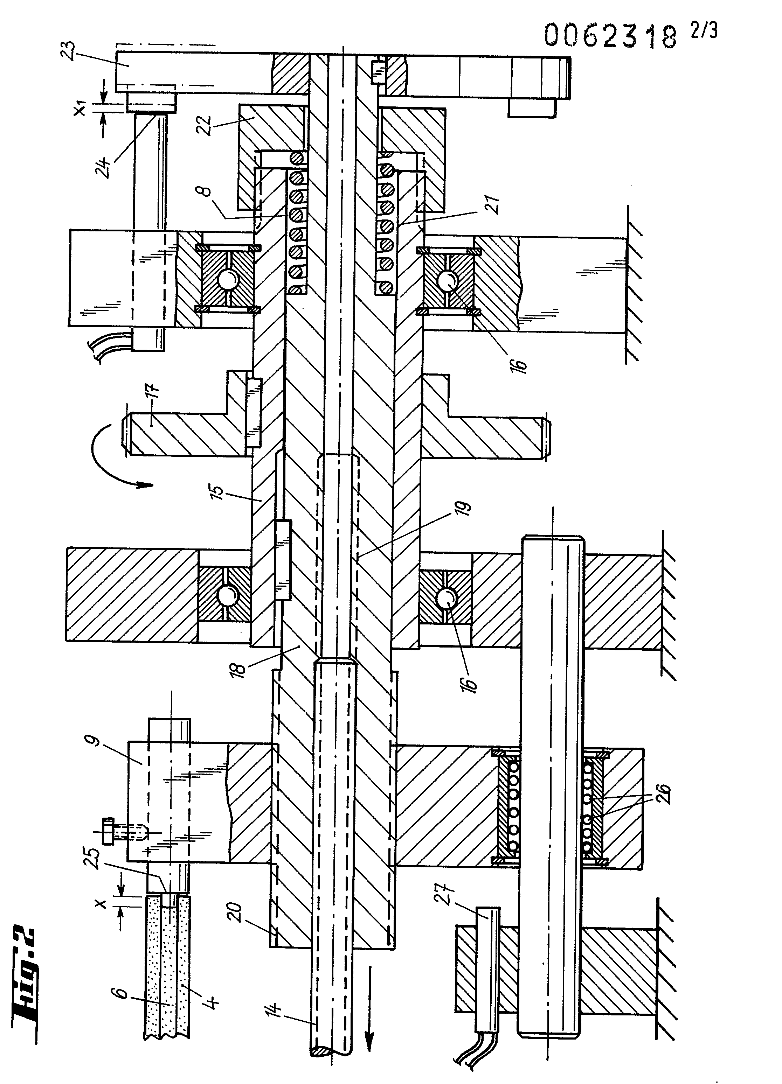

Figur 1 und 2   einen geteilten Längsschnitt durch die Gesamtvorrichtung auf zwei Blatt und

- 4 -

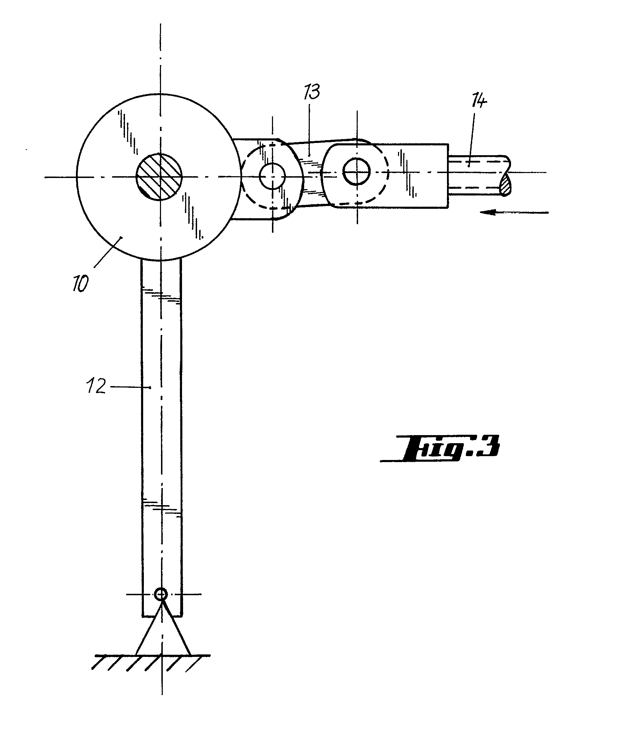

Figur 3  eine Draufsicht auf die Schleifscheibenlagerung.

Wie aus der Zeichnung ersichtlich wird, erfolgt die Zuführung von Leiterplatten 1 mittels angetriebenen Unterrollen 2 und federnd aufliegenden Führungsrollen 3 zwischen zwei Umfangsschleifscheiben 4, wovon hier nur die eine Seite gezeigt ist, während die andere spiegelbildlich dazu liegt. Der berührungslose Einschalter 5 gibt beim Einfahren einer Leiterplatte 1 die Betätigung der Vorrichtung frei. Die Umfangsschleifscheibe 4 liegt mit beim Kantenschleifen entstehender Umfangsnut 6, wie ersichtlich, dem Plattenrand 7 bei dessen Durchlauf an. Hierbei erfolgt die Anlage unabhängig von der Abnutzung des Schleifscheibenumfangs unter nahezu konstant gehaltener Federkraft 8, wobei die Nachstellunggekoppelt ist mit der Abrichtvorrichtung 9, welche entsprechend am Umfang der Schleifscheibe 4 zur Anlage kommt, wie dies im folgenden näher beschrieben wird.

Die Schleifscheibenlagerung 10 mit Antriebsrad 11 erfolgt an einem quer zur Zustelleinrichtung liegenden Schwenkarm 12, während eine Schraubpinole unter Zwischenschaltung einer Lasche 13 zur Ausschaltung des Schwenkradius die Anlage der Schleifscheibe über die Druckbolzen 14 bewirkt. Hierbei besteht die Schraubpinole aus einer dreh- und unverschiebbar gelagerten Aufnahmehülse 15 mit Lagern 16 und Antriebsrad 17 (Pinolentrieb). In dieser Aufnahmehülse 15 ist

- 5 -

gegen Federwirkung 8 die mitdrehende Schraubhülse 18 längsverschiebbar, welche (18) mit Innengewinde 19 den nicht drehbaren Druckbolzen 14 verschraubbar für die Zustellung der Schleifscheibe 4
und mit Außengewinde 20 die längsgeführte Abrichtvorrichtung 9 schraubbar aufnimmt. Das Außengewinde 20 für die gleichläufige Abrichtvorrichtung 9
besitzt gegenüber dem Innengewinde 19 für die
Schleifscheibenzustellung doppelte Steigung, so daß
bei zustellbarer Schleifscheibe 4 die Abrichtvorrichtung 9 sowohl um die Zustellstrecke als auch
um die Schleifabnutzungsstrecke angestellt wird.

Die Feder 8 für die Nachstellung der Schleifscheibe 4 liegt als Schraubenfeder in der zylindrischen
Ausnehmung 21 am Ende der Schraubhülse 18 und stützt
sich gegen die verstellbar aufgeschraubte Endkappe 22
der unverschiebbaren Aufnahmehülse 15 ab, wie dies
aus der Zeichnung ersichtlich wird. Mit der Feder 8
läßt sich somit der Anpreßdruck der Schleifscheibe 4
am Plattenrand 7 einstellen. Durch die Endkappe 22 der
Aufnahmehülse 15 reicht die verschiebbare Schraubhülse 18, welche eine Endscheibe 23 trägt, die bei einstellbarem Zustellbereich den gegebenenfalls berührungslosen Schalter 24 für den Pinolenantrieb 17 betätigt.

Die Abrichtvorrichtung 9 auf dem Außengewinde 20 der
Schraubhülse 18 liegt hierdurch mittels Diamantabrichter 25 dem Schleifscheibenumfang gleichmäßig an
und hält die Nuttiefe etwa konstant. Hierbei kann
der Diamantabrichter 25 noch auf- und abbewegbar

- 6 -

sein, wie dies hier nicht besonders dargestellt ist.

Überdies betätigt die mittels Gleitlager 26 geführte Abrichtvorrichtung 9 einen gegebenenfalls berührungslosen Ausschalter 27 beim Erreichen einer vorbestimmten Schleifscheibenabnutzung, d.h. beim Erreichen des gewünschten Minimalumfangs und damit notwendigem Schleifscheibenwechsel. Im übrigen werden hier am besten Umfangsschleifscheiben 4 mit gewisser Elastizität verwendet, um das gewünschte Ergebnis zu erreichen.

In der Zeichnung ist beispielsweise die Nuttiefe X an der Schleifscheibe 4 erreicht, bei welcher der Schalter 24 betätigt wird und damit die Zustellung $X_1$ bei entsprechendem Abstand an der Endscheibe 23 vom Schalter 24 durch Rücklauf gegen Federwirkung 8 bei weiter anliegender Schleifscheibe 4 erreicht wird, während gleichzeitig die Abrichtvorrichtung 9 um $X_2 = 2 \times X_1$ vorläuft und damit sowohl die Gegenstellstrecke $X_1$ ausgleicht als auch eine Abrichtung $X_1$ zur Umfangsabtragung der Schleifabnutzung der Umfangsnut 6 bewirkt.

- 7 -

Patentansprüche:

1. Vorrichtung zum Kantenschleifen - Glätten und Entgraten der Plattenränder - von plattenförmigem Gut, insbesondere Leiterplatten der Elektronikindustrie, wobei das Gut mittels wenigstens teilweise angetriebenen Rollen an ein- oder beidseitig anliegenden Schleifscheiben vorbeiführbar ist, dadurch gekennzeichnet, daß dieselbe(n) als Umfangsschleifscheibe(n) bei Abnutzung unter nahezu konstant gehaltener Federkraft mit beim Kantenschleifen entstehender Umfangsnut den Plattenrändern anlegbar ist (sind) und die mit der Nachstellung gekoppelte Abrichtung selbsttätig für etwa gleichbleibende Nuttiefe sorgt.

2. Vorrichtung nach Anspruch 1, dadurch gekennzeichnet, daß die mit ihrer Antriebslagerung geführte(n) Schleifscheib(n) bei unter Federwirkung stehender Schraubpinole(n) mit etwa konstanter Federkraft nachstellbar ist (sind) und auf jeder Schraubpinole eine Abrichtvorrichtung sitzt, welche am Umfang der Schleifscheibe anliegt.

3. Vorrichtung nach Anspruch 2, dadurch gekennzeichnet, daß das Schleifscheibenlager an einem quer zur Zustelleinrichtung liegenden Schwenkarm angeordnet ist und die Schraubpinole unter Zwischenschaltung einer Lasche zur Ausschaltung des Schwenk-

0062318

bogeneinflusses die Nachstellung bewirkt.

4. Vorrichtung nach Anspruch 2 oder 3, dadurch gekennzeichnet, daß die Schraubpinole aus einer dreh- und unverschiebbar gelagerten, antreibbaren Aufnahmehülse - Pinolenantrieb - besteht, in welcher gegen Federwirkung eine mitdrehende Schraubhülse längsverschiebbar ist, welche mit Innengewinde einen nichtdrehbaren Druckbolzen verschraubbar für die Schleifscheibenzustellung und mit Außengewinde die längsgeführte Abrichtvorrichtung schraubbar aufnimmt.

5. Vorrichtung nach Anspruch 4, dadurch gekennzeichnet, daß das Außengewinde für die gleichläufige Abrichtvorrichtung gegenüber dem Innengewinde für die Schleifscheibenzustellung doppelte Steigung besitzt, so daß bei zustellbarer Schleifscheibe die Abrichtvorrichtung sowohl um die Zustellstrecke als auch um die Schleifabnutzungsstrecke anstellbar ist.

6. Vorrichtung nach einem der vorhergehenden Ansprüche, dadurch gekennzeichnet, daß die Feder für die Nachstellung der Schleifscheibe als Schraubenfeder in einer zylindrischen Ausnehmung am Ende der Schraubhülse liegt und sich gegen eine verstellbar aufgeschraubte Endkappe der unverschiebbaren Aufnahmehülse abstützt.

- 9 -

7. Vorrichtung nach Anspruch 6, dadurch gekennzeichnet, daß an der durch die Endkappe der Aufnahmehülse reichenden, verschiebbaren Schraubhülse eine Endscheibe aufgesetzt ist, welche bei einstellbarem Zustellbereich einen Schalter für den Pinolenantrieb betätigt.

8. Vorrichtung nach einem der vorhergehenden Ansprüche, dadurch gekennzeichnet, daß beim Einfahren des plattenförmigen Gutes zwischen die Schleifscheiben von diesem ein Einschalter zur Freigabe der Pinolenzustellung betätigbar ist.

9. Vorrichtung nach einem der vorhergehenden Ansprüche, dadurch gekennzeichnet, daß beim Erreichen einer vorbestimmbaren Schleifscheibenabnutzung – Umfangsverkleinerung – von der Abrichtvorrichtung ein Ausschalter betätigbar ist.

10. Vorrichtung nach einem der vorhergehenden Ansprüche, gekennzeichnet durch die Verwendung von mfangsschleifscheiben auf elastischer Basis.

Fig.1

0062318/3

**Fig.2**

0062318 2/3

10   12   13   14

Fig.3

Europäisches
Patentamt

# EUROPÄISCHER RECHERCHENBERICHT

0062318

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | FR-A-   580 838   (MICHAUD) | 1 | B 24 B     9/06 |
| A | FR-A-1 509 195   (APPRO) | | |
| A | DE-A-3 026 272   (NAGANO) | | |
| A | FR-A-2 304 445   (ANDERSON) | | |
| A | DE-B-1 104 856   (FOUQUET) | | |
| A | US-A-2 929 172   (PASELL) | | |

----

RECHERCHIERTE
SACHGEBIETE (Int. Cl. ³)

B 24 B

Der vorliegende Recherchenbericht wurde für alle Patentansprüche erstellt.

| Recherchenort DEN HAAG | Abschlußdatum der Recherche 28-06-1982 | Prüfer PEETERS S. |
|---|---|---|